(19) Europäisches Patentamt
European Patent Office
Office européen des brevets

(11) **EP 4 510 220 A1**

(12) **EUROPEAN PATENT APPLICATION**
published in accordance with Art. 153(4) EPC

(43) Date of publication:
**19.02.2025 Bulletin 2025/08**

(51) International Patent Classification (IPC):
**H01M 4/134** (2010.01)    **H01M 4/1395** (2010.01)

(21) Application number: **22957728.3**

(52) Cooperative Patent Classification (CPC):
**H01M 4/134; H01M 4/1395**

(22) Date of filing: **08.09.2022**

(86) International application number:
**PCT/CN2022/117824**

(87) International publication number:
**WO 2024/050756 (14.03.2024 Gazette 2024/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Contemporary Amperex Technology Co., Limited**
**Ningde, Fujian 352100 (CN)**

(72) Inventors:
• **WU, Kai**
**Ningde, Fujian 352100 (CN)**

• **DENG, Jingxian**
**Ningde, Fujian 352100 (CN)**
• **WANG, Jiazheng**
**Ningde, Fujian 352100 (CN)**
• **LV, Zijian**
**Ningde, Fujian 352100 (CN)**
• **LIU, Liangbin**
**Ningde, Fujian 352100 (CN)**
• **LI, Yuan**
**Ningde, Fujian 352100 (CN)**

(74) Representative: **Ziebig Hengelhaupt Intellectual Property Attorneys**
**Patentanwaltskanzlei PartGmbB**
**Leipziger Straße 49**
**10117 Berlin (DE)**

(54) **SILICON-CARBON NEGATIVE ELECTRODE MATERIAL AND PREPARATION METHOD THEREFOR, SECONDARY BATTERY AND ELECTRIC DEVICE**

(57)    A silicon carbon negative material is provided. The silicon carbon negative material includes a porous carbon base, nano-silicon crystal grains located in pores of the porous carbon base, and a carbon coating layer located on a surface of the porous carbon base. The nano-silicon crystal grains include an elemental silicon core and a $Li_xSi_y$ coating layer, x is an integer selected from 7 to 22, and y is an integer selected from 3 to 7.

FIG. 1

EP 4 510 220 A1

**Description**

**FIELD**

The present disclosure relates to the field of secondary batteries, and more particularly, to a silicon carbon negative material and a preparation method thereof, a secondary battery, and an electrical device.

**BACKGROUND**

The description herein merely provides background information related to the present disclosure, and does not necessarily constitute prior art.

Silicon is a kind of high specific volume material that can be used as negative material, which has a high specific volume greater than 10 times of that of the current common graphite negative electrode. Furthermore, silicon has high safety, abundant resource reserves and low preparation cost. Carbon materials have relatively high electrical conductivity, a relatively stable structure, small volume expansion in the cycle process which is usually below 10%, and good flexibility and lubricity. Silicon carbon negative materials can greatly improve the performance of secondary batteries if they can combine their advantages. However, although the capacity of the synthesized silicon carbon materials has been improved compared with the conventional technology, the first efficiency of the synthesized silicon carbon materials is relatively low, and the expansion problem of the silicon materials in the cycle process has not been well solved, so it is difficult to meet the actual requirements.

**SUMMARY**

According to various embodiments of the present disclosure, a first aspect of the present disclosure provides a silicon carbon negative material. The silicon carbon negative material includes a porous carbon base, nano-silicon crystal grains located at least partially in pores of the porous carbon base, and a carbon coating layer located on at least part of a surface of the porous carbon base or the nano-silicon crystal grains. The nano-silicon crystal grains include an elemental silicon core and a $Li_xSi_y$ coating layer, x is an integer selected from 7 to 22, and y is an integer selected from 3 to 7.

The nano-silicon crystal grains are filled in the pores of the porous carbon base, such that the expansion of the silicon material during the cycle process can be effectively suppressed. The lithium-silicon coating layer of the nano-silicon crystal grains can avoid the active lithium in the battery from being un-replenished after being consumed. Further, the lithium-silicon coating layer is in combination with the carbon coating layer that can reduce the overall specific surface area of the silicon carbon negative material, such that the consumption of active lithium in the system can be effectively reduced, the first efficiency and cycle performance of the battery can be improved, and the balance and common improvement of several performance can be achieved.

In some embodiments, the nano-silicon crystal grains satisfy one or more of the following conditions (1) to (3):

(1) a size of each of the nano-silicon grains is smaller than 10 nm; optionally, the size of the nano-silicon grain is in a range of 1 nm to 6 nm; the nano-silicon crystal grains are controlled in a suitable range, to facilitate to improve the cycle performance of the material;
(2) a material of the $Li_xSi_y$ coating layer includes one or more of $Li_7Si_3$, $Li_{12}Si_7$, $Li_{13}Si_4$, $Li_{15}Si_4$, and $Li_{22}Si_5$; $Li_xSi_y$ is a reversible material, can deintercalate active lithium during the cycle process, and is used for lithium replenishment of the battery, to improve the first efficiency of the battery; or
(3) an outer layer of lithium silicate salt is provided on at least part of a surface of the $Li_xSi_y$ coating layer; optionally, a material of the outer layer of lithium silicate salt includes one or more of $Li_2SiO_3$, $Li_4SiO_4$, and $Li_2Si_2O_5$; the outer layer of lithium silicate salt can avoid more active lithium consumption during the formation process, further improving the first efficiency of the battery.

In some embodiments, the silicon carbon negative material satisfies one or more of the following conditions (1) to (6):

(1) a porosity of the silicon carbon negative material is smaller than 40% as measured under nitrogen adsorption; optionally, the porosity of the silicon carbon negative material is in a range of 20% to 35% as measured under nitrogen adsorption; the porosity of the resulting silicon carbon negative electrode product is controlled within a suitable range, which can effectively inhibit the expansion of the silicon material while making the material have good mechanical strength and stability, and avoid the occurrence of crushing during the cycle process;
(2) a specific surface area of the silicon carbon negative material is smaller than 6 $m^2/g$; optionally, the specific surface area of the silicon carbon negative material is in a range of 1 $m^2/g$ to 4 $m^2/g$; a suitable specific surface area can avoid excessive consumption of active lithium when an SEI film is formed on the surface of the material, which can further enhance the first efficiency of the material;

(3) a Dv50 particle size of the silicon carbon negative material is in a range of 5 $\mu$m to 11 $\mu$m; optionally, the Dv50 particle size of the silicon carbon negative material is in a range of 7 $\mu$m to 9 $\mu$m; a suitable particle size can avoid decrease of the first efficiency caused by an excessive specific surface area and deterioration of material dynamic performance caused by an excessive particle size;

(4) in the silicon carbon negative material, a mass percentage content of a carbon element is in a range of 35% to 60%, a mass percentage content of a silicon element is in a range of 30% to 60%, a mass percentage content of a lithium element is in a range of 0.5% to 5%, and a mass percentage content of an oxygen element is in a range of 2% to 10%; a content of each of the above elements is in a suitable range, such that a capacity of the material can be increased as much as possible under the premise of effectively inhibiting expansion of the material, and the material has a higher first efficiency;

(5) an X-ray diffraction pattern of the silicon carbon negative material has a diffraction peak in a range of 22° to 24°, and the diffraction peak between 22° to 24° is a characteristic peak of a (221) crystal plane of $Li_{12}Si_7$; or

(6) the X-ray diffraction pattern of the silicon carbon negative material has a diffraction peak in a range of 26° to 27°, and the diffraction peak between 26° to 27° is a characteristic peak of the (111) crystal plane of $Li_2SiO_3$.

In some embodiments, a thickness of the carbon coating layer is equal to or smaller than 1.5 $\mu$m; optionally, the thickness of the carbon coating layer is in a range of 0.1 $\mu$m to 0.5 $\mu$m. The thickness of the carbon coating layer is controlled within a suitable range, which can form a stable and complete coating film on the surface of the porous carbon base, and can help to control the specific surface area within a suitable range. Further, an SEI film (solid electrolyte interface) is not easily formed due to the fact that the coating film is too thick, which may result in loss of active lithium and affect the first efficiency of the material.

In a second aspect of the present disclosure, there is provided a preparation method of the silicon carbon negative material according to one or more of the preceding embodiments. The preparation method includes steps of:

a. depositing elemental silicon in the pores of the porous carbon base;
b. performing carbon coating treatment on a product formed in the previous step; and
c. reacting a product of the previous step with a lithium source,
wherein the preparation method is performed in an order of a-b-c or a-c-b. It will be appreciated that the steps of carbon coating treatment and pre-lithiation reaction can be performed in any order, as the lithium source does not react with the carbon coating layer and may pass through the carbon coating layer to react with the elemental silicon deposited in the porous carbon base.

In some embodiments, the porous carbon base satisfies one or more of the following conditions (1) to (4):

(1) a porosity of the porous carbon base is in a range of 40% to 70% as measured under nitrogen adsorption; optionally, the porosity of the porous carbon base is in a range of 40% to 50% as measured under nitrogen adsorption; in the raw material of the porous carbon base, the pores not only extend on the surface, but also extend to the interior of the material, such that the silicon material can deposit on the porous carbon base, which can inhibit the expansion of silicon; the porosity of the porous carbon base is controlled in a suitable range, enabling the silicon material to be uniformly deposited in the pores to form grains with a suitable particle size, and obtaining a resulting silicon carbon negative material with a suitable porosity, thereby effectively inhibiting the expansion of the silicon material and enabling the resulting product to have a sufficient mechanical strength and capacity;

(2) a pore size of the porous carbon base is in a range of 1 nm to 200 nm; optionally, the pore size of the porous carbon base is in a range of 2 nm to 100 nm; the pore size of the porous carbon base is controlled in a suitable range, facilitating the formation of silicon grains with a suitable particle size in the pore, and inhibiting the expansion of the porous carbon base in the cycle process; it will be appreciated that the pore size of the carbon base is not absolutely constrained by the size of the nano-silicon grains, as it is not required that all pores of the porous carbon base have silicon grains deposited therein; the pores without a deposited silicon grain can reserve aperture gaps for the expansion of silicon, thereby further alleviating the material expansion;

(3) a number proportion of mesopores in the porous carbon base is in a range of 10% to 65%; optionally, the number proportion of mesopores is in a range of 40% to 55%; wherein the mesopores are pores having a pore size in a range of 2 nm to 50 nm; the number proportion of the mesoporosity of the porous carbon base is controlled to be beneficial to the uniform distribution of silicon and carbon in the material, preventing local enrichment of silicon particles in the material, and making the resulting product have a sufficient mechanical strength; or

(4) a Dv50 particle size of the porous carbon base is in a range of 3 $\mu$m to 10 $\mu$m; optionally, the Dv50 particle size of the porous carbon base is in a range of 4 $\mu$m to 8 $\mu$m; the particle size of the porous carbon base is controlled in a suitable range to facilitate the formation of a resulting silicon carbon negative material with a suitable particle size, thereby balancing dynamic properties and the first efficiency of the material.

In some embodiments, the depositing elemental silicon in step a includes:

placing the porous carbon base in a vacuum chamber filled with a protective gas; and
supplying a silicon source gas into the vacuum chamber and heating the vacuum chamber, decomposing the silicon source gas to form elemental silicon, and depositing the elemental silicon in the pores of the porous carbon base. Elemental silicon grains that are uniformly distributed and have a suirable grain size can be easily and controllably formed by filling the silicon material with a gaseous silicon source.

In some embodiments, step a satisfies one or more of the following conditions (1) to (5):

(1) a vacuum degree of the vacuum chamber is in a range of 100 Pa to 800 Pa before the protective gas is filled;
(2) the protective gas includes one or more of nitrogen, argon, and hydrogen;
(3) the silicon source gas includes one or more of silane, dichlorosilane, trichlorosilane, and tetrachlorosilane;
(4) a volume ratio of the protective gas and the silicon source gas is 1:(1-10); or
(5) the heating the vacuum chamber includes: increasing a temperature of the vacuum chamber to be in a range of 600°C to 1000°C, and maintaining the temperature for 1 h to 4 h; and decreasing the temperature to be in a range of 450°C to 550°C, and maintaining the temperature for 1 h to 6 h.

Suitable deposition conditions are advantageous to allow the silicon grains to be deposited more uniformly in the pores of the porous carbon base and form particles of the proper size. For example, the volume ratio of the protective gas to the silicon source gas is configured to adjust an effective concentration of the silicon source gas. When the effective concentration of the silicon source gas is high, the reaction rate is relatively fast, which is not conducive to the deposition of silicon in the pore structure of the carbon base, resulting in uneven distribution of silicon and carbon of resulting particles. The silicon is distributed more on the surface of the resulting particles. In the cycle process, the surface expansion is too great, which may cause particle breakage and affect the cycle performance. When the effective concentration of the silicon source gas is low, the reaction is slow and the reaction time is too long, which may easily lead to the silicon grain size being larger. Accordingly, the carbon base can not effectively restrict its expansion, which may easily lead to particle breakage in the cycle process and affect the circulation. For example, at the beginning of the reaction, there are many pores in the carbon base, such that a relatively high reaction temperature can be set to enable the silicon to rapidly fill the pores. However, when the temperature exceeds 1000°C, the reaction rate is too fast, and the silicon particles directly decompose at mouths of the pores to block the pores. Accordingly, the silicon particles that are subsequently decomposed cannot continue to fill the pores. A lower reaction temperature is set in a second stage to reduce the reaction rate and allow silicon to continue to fill the remaining pores, further reducing the porosity of the material and allowing a porosity of the resulting product to be below 40%.

In some embodiments, the carbon coating treatment in step b includes: supplying a non-reactive gas and a carbon source gas, decomposing the carbon source gas to form elemental carbon under heating conditions, and depositing elemental carbon on a surface of a product obtained in the preceding step to prepare the carbon coating layer. A carbon source gas is used to prepare the carbon coating layer, such that the thickness of the carbon coating layer can be conveniently controlled to achieve complete coating of the porous carbon base.

In some embodiments, step b satisfies one or more of the following conditions (1) to (3):

(1) the non-reactive gas includes one or more of nitrogen and argon;
(2) the carbon source gas includes one or more of methane, ethane, ethylene, and acetylene; or
(3) the heating conditions include a temperature in a range of 600°C to 950°C and a duration in a range of 0.2 h to 2 h.

Suitable carbon coating conditions are advantageous for controlling the carbon coating layer within a suitable thickness range, effectively covering voids of the surface of the porous carbon base to reduce the specific surface area of the resulting product and improve the electrical conductivity of the material.

In some embodiments, step c satisfies one or more of the following conditions (1) to (3):

(1) the lithium source includes one or more of lithium carbonate, lithium acetate, lithium oxide, lithium hydroxide, lithium chloride, butyl lithium, phenyl lithium, methyl lithium, lithium amide, and lithium hydride;
(2) a mass ratio of the product obtained in the preceding step to the lithium source is 1:(0.02-0.1); or
(3) a reaction temperature is in a range of 400°C to 700°C.

Suitable pre-lithiation conditions facilitate the formation of more desirable nano-silicon grains. For example, a $Li_xSi_y$ coating layer and an outer layer of lithium silicate salt that have proper proportions can be obtained by controlling the mass ratio of the product to the lithium source, to avoid that the outer layer of lithium silicate salt accounts for too much, and the reversible $Li_xSi_y$ coating layer accounts for too little to affect the capacity and first efficiency of the material. For another example, a suitable reaction temperature can avoid a low reaction efficiency and incomplete reaction caused by the too low temperature to form residues, and can also avoid continuous growth of the grains caused by the too high temperature. Accordingly, the size of the nano-silicon grains can be controlled within a suitable range, to further ensure the capacity and cycle performance of the material.

In some embodiments, the porous carbon base rotates and maintains a rotational speed in a range of 0.5 rpm to 3 rpm. The raw material of the porous carbon base rotates at a speed during the preparation, to enable the silicon source gas and the carbon source gas to be more uniformly deposited on the inner voids and the surface of the porous carbon. The manner of controlling the rotation of the raw material of the porous carbon base may employ a vacuum chamber with a rotary function and set the rotational speed of the apparatus to a predetermined range.

In a third aspect of the present disclosure, there is provided use of the silicon carbon negative material according to one or more of the preceding embodiments in preparation of a secondary battery. The silicon carbon negative material of the present disclosure is used to prepare a secondary battery, such that the capacity and first efficiency of the battery can be effectively improved, and the expansion of the silicon material can be controlled, thereby improving the cycle performance of the battery.

In a fourth aspect of the present disclosure, there is provided a secondary battery including a positive electrode plate, a negative electrode plate, and a separator provided between the positive electrode plate and the negative electrode plate. The negative electrode plate includes a negative electrode current collector and a negative active material layer provided on at least one surface of the negative electrode current collector. The negative active material layer includes the silicon carbon negative material according to one or more of the preceding embodiments.

In a fifth aspect of the present disclosure, there is provided an electrical device including the preceding secondary battery.

The details of one or more embodiments of the disclosure are set forth in the accompanying drawings and the description below. Other features, objects, and advantages of the disclosure will be apparent from the description and drawings, and from the claims.

## BRIEF DESCRIPTION OF DRAWINGS

For a better description and illustration of embodiments or examples disclosed herein, reference may be made to one or more of the accompanying drawings. The additional details or examples used to describe the drawings should not be considered as limitation on the scope of the present disclosure, the presently described embodiments or examples, and any presently understood best mode of the present disclosure.

FIG. 1 is a schematic view of a secondary battery according to an embodiment of the present disclosure.
FIG. 2 is an exploded view of the secondary battery of the embodiment of the present disclosure shown in FIG. 1.
FIG. 3 is a schematic view of an electrical device using a secondary battery as a power source according to an embodiment of the present disclosure.

Reference signs:
1 Secondary battery; 11 Casing; 12 Electrode assembly; 13 Cover plate; 2 electrical device.

## DESCRIPTION OF EMBODIMENTS

In order to make the objects, technical solutions and advantages of the present disclosure more apparent, the present disclosure is further described in detail below with reference to the accompanying drawings and embodiments. It should be understood that the specific embodiments described herein are merely illustrative of the present disclosure and do not limit the persent disclosure thereto.

Unless otherwise defined, all technical and scientific terms used in the present disclosure have the same meaning as commonly understood by those skilled in the art of the present disclosure. The terms used in the description of the present disclosure are only for the purpose of describing specific embodiments and are not intended to limit the present disclosure. As used herein, the term "and/or" includes any combination and all combinations of one or more of the associated listed items.

The "ranges" disclosed herein are defined in terms of lower and upper limits, a given range is defined by selecting a lower limit and an upper limit, and the selected lower and upper limits defines boundaries of a particular range. Ranges defined in this manner may or may not include end values and may be arbitrarily combined, i.e., any lower limit may be combined with any upper limit to form a range. For example, if ranges of 60 to 120 and 80 to 110 are listed for a particular parameter, it is understood that ranges of 60 to 110 and 80 to 120 are also contemplated. In addition, if listed minimum range values are 1 and 2 and if listed maximum range values are 3, 4, and 5, the following ranges are all conceivable: 1 to 3, 1 to 4, 1 to 5, 2 to 3, 2 to 4, and 2 to 5. In the present application, unless otherwise indicated, the numerical range "a to b" represents an abbreviated representation of any real number combination between a and b, where a and b are both real numbers. For example, a numerical range of "0 to 5" indicates that all real numbers between "0 to 5" have been fully included herein, and "0 to 5" is merely a shorthand representation of combinations of these numbers. In addition, when it is stated that a certain parameter is an integer equal to or greater than 2, it is equivalent to disclosing that the parameter is, e.g., an integer of 2, 3, 4, 5, 6, 7, 8, 9, 10, 11, 12, etc.

All embodiments and alternative embodiments of the present application may be combined with each other to form a new technical solution if not specifically stated.

Unless otherwise specified, all the technical features and optional technical features of the present application may be combined with each other to form a new technical solution.

Unless otherwise specified, all steps of the present application may be performed sequentially or may be performed randomly, preferably sequentially. For example, the process includes steps (a) and (b), meaning that the process may include steps (a) and (b) performed sequentially, or may include steps (b) and (a) performed sequentially. For example, the process may further include step (c), meaning that step (c) may be added to the process in any order, e.g., the process may include steps (a), (b), and (c), include steps (a), (c), and (b), or include steps (c), (a), and (b) or the like.

If not specifically stated, "including" and "incorporating" described herein are intended to be open-ended as well as closed-ended. For example, "including" and "comprising" may mean that other components not listed may be included or incorporated, or that only listed components may be included or incorporated.

In the present application, the term "or" is inclusive if not specifically stated. For example, a phrase "A or B" means "A, B, or both A and B". More specifically, a condition of "A or B" is satisfied by any one of the following conditions: A is true (or present) and B is false (or not present); A is false (or absent) and B is true (or present); or both A and B are true (or present).

With the increasing market demand for high capacity batteries, non-carbon negative materials such as silicon-based negative materials have been rapidly developed. However, due to the serious volume expansion, poor conductivity, low first efficiency and poor cycle performance of silicon-based negative electrode during lithiation, the commercial application of silicon-based negative electrode is greatly restricted. In order to be able to use silicon materials for negative electrodes, silicon-containing composite materials such as silicon carbon negative materials and silicon-oxygen negative materials have been studied. At present, pre-lithiation treatment is perforemed on the silicon-oxygen negative material to obtain superior first efficiency and cycle performance, but the capacity still cannot reach a higher level. The silicon carbon negative materials can improve the capacity, but there are obvious disadvantages for the first efficiency and cycle performance. It is obvious from the above that it is difficult for current silicon-containing composites to balance the contradiction between several properties and achieve a common improvement.

Based on the above background, in a first aspect of the present disclosure, there is provided a silicon carbon negative material including a porous carbon base, nano-silicon crystal grains, and a carbon coating layer. The nano-silicon crystal grains are located at least partially inside pores of the porous carbon base, and the carbon coating layer is located on at least part of a surface of the porous carbon base or the nano-silicon crystal grains.

The nano-silicon crystal grains inlcude an elemental silicon core and a $Li_xSi_y$ coating layer, x is an integer selected from 7 to 22, and y is an integer selected from 3 to 7. Optionally, x may be, for example, 8, 10, 12, 13, 15, 18, 20, or 22, and y may be, for example, 3, 4, 5, 6, or 7.

The nano-silicon crystal grains are filled in the pores of the porous carbon base, such that the expansion of the silicon material during the cycle process can be effectively suppressed. The lithium-silicon coating layer of the nano-silicon crystal grains can avoid the active lithium in the battery from being un-replenished after being consumed. Further, the lithium-silicon coating layer is in combination with the carbon coating layer that can reduce the overall specific surface area of the silicon carbon negative material, such that the consumption of active lithium in the system can be effectively reduced, the first efficiency and cycle performance of the battery can be improved, and the balance and common improvement of several performance can be achieved.

In some embodiments, the nano-silicon crystal grains satisfy one or more of the following conditions (1) to (3).

As for condition (1), the size of the nano-silicon crystal grain is smaller than 10 nm. Optionally, the size of the nano-silicon crystal grain is in a range of 1 nm to 6 nm. For example, the size of the nano-silicon crystal grain may be, 9 nm, 8 nm, 7 nm, 6 nm, 5 nm, 4 nm, 3 nm, 2 nm or 1 nm. The nano-silicon crystal grain is controlled in a suitable range, to be more conducive to improving the cycle performance of the material.

It is to be understood that in the present disclosure, the nano-silicon crystal grains may be separately deposited in the pores of the porous carbon base, or one nano-silicon grain composed of a plurality of crystal grains may be deposited in the pores.

It is understood that, in the present disclosure, the "size" is the size of a single crystal grain, and the corresponding crystal grain size is calculated from the corresponding diffraction peak of XDR. The size of silicon crystal grain is calculated as a diffraction peak corresponding to a (111) crystal plane, and the size of $Li_2SiO_3$ crystal grain is calculated as adiffraction peak corresponding to a (111) crystal plane.

As for condition (2), a material of the $Li_xSi_y$ coating layer includes one or more of $Li_7Si_3$, $Li_{12}Si_7$, $Li_{13}Si_4$, $Li_{15}Si_4$, and $Li_{22}Si_5$. $Li_xSi_y$ is a reversible material, can deintercalate active lithium during the cycle process, and is used for lithium replenishment of the battery, to improve the first efficiency of the battery.

As for condition (3), an outer layer of lithium silicate salt is provided on at least part of a surface of the $Li_xSi_y$ coating layer. Optionally, a material of the lithium silicate salt outer layer includes one or more of $Li_2SiO_3$, $Li_4SiO_4$, and $Li_2Si_2O_5$. The outer layer of lithium silicate salt can avoid more active lithium consumption during the formation process, further improving the first efficiency of the battery.

In some embodiments, the silicon carbon negative material satisfies one or more of the following conditions (1) to (6).

As for condition (1), a porosity of the silicon carbon negative material is smaller than 40% measured under nitrogen adsorption. Optionally, the porosity of the silicon carbon negative material is in a range of 20% to 35 % measured under nitrogen adsorption. For example, the porosity of the silicon carbon negative material may be 35%, 30%, 25%, 20%, 15%, 10%, or 5% measured under nitrogen adsorption. The porosity of the resulting silicon carbon negative electrode product is controlled within a suitable range, which can effectively inhibit the expansion of the silicon material while making the material have good mechanical strength and stability, and avoid the occurrence of crushing during the cycle process.

As for condition (2), a specific surface area of the silicon carbon negative material is smaller than 6 $m^2/g$. Optionally, the specific surface area of the silicon carbon negative material is in a range of 1 $m^2/g$ to 4 $m^2/g$. For example, the specific surface area of the silicon carbon negative material may be 5 $m^2/g$, 4 $m^2/g$, 3 $m^2/g$, 2 $m^2/g$, or 1 $m^2/g$. A suitable specific surface area can avoid excessive consumption of active lithium when an SEI film is formed on the surface of the material, which can further enhance the first efficiency of the material.

As for condition (3), a Dv50 particle size of the silicon carbon negative material is in a range of 5 $\mu$m to 11 $\mu$m. Optionally, the Dv50 particle size of the silicon carbon negative material is in a range of 7 $\mu$m to 9 $\mu$m. For example, the Dv50 particle size of the silicon carbon negative material may be 6 $\mu$m, 7 $\mu$m, 8 $\mu$m, 9 $\mu$m, or 10 $\mu$m. A suitable particle size can avoid decrease of the first efficiency caused by an excessive specific surface area and deterioration of material dynamic performance caused by an excessive particle size.

In the present disclosure, the Dv50 refers to the particle size corresponding to the cumulative volume distribution number of particles of 50% in a volume cumulative distribution curve of the particle size, and its physical meaning is that a volume proportion of a particle with a particle size smaller than or greater than this particle size value is 50%. In an example, the Dv50 is conveniently determined by a laser particle size analyser, such as an Mastersizer 2000E laser particle size analyser from Malvern Instruments Ltd. of British, with reference to GB/T 19077-2016 particle size distribution laser diffraction.

As for condition (4), in the silicon carbon negative material, a mass percentage content of a carbon element is in a range of 35% to 60%, a mass percentage content of a silicon element is in a range of 30% to 60%, a mass percentage content of a lithium element is in a range of 0.5% to 5%, and a mass percentage content of an oxygen element is in a range of 2% to 10%. Optionally, the mass percentage content of the carbon element may be, for example, 45%, 50%, or 55%, the mass percentage content of the silicon element may be, for example, 35%, 40%, 45%, 50%, or 55%, the mass percentage content of the lithium element may be, for example, 1%, 2%, 3%, or 4%, and the mass percentage content of the oxygen element may be, for example, 4%, 6%, or 8%. A content of each of the above elements is in a suitable range, such that a capacity of the material can be increased as much as possible under the premise of effectively inhibiting expansion of the material, and the material has a higher first efficiency.

As for condition (5), in an X-ray diffraction pattern of the silicon carbon negative material, a diffraction peak exists in a range of 22° to 24°, and the diffraction peak between 22° to 24° is a characteristic peak of a (221) crystal plane of $Li_{12}Si_7$.

As for condition (6), in the X-ray diffraction pattern of the silicon carbon negative material, a diffraction peak exists in a range of 26° to 27°, and the diffraction peak between 26° to 27° is a characteristic peak of the (111) crystal plane of $Li_2SiO_3$.

In some embodiments, a thickness of the carbon coating layer is equal to or smaller than 1.5 $\mu$m. Optionally, the thickness of the carbon coating layer is in a range of 0.1 $\mu$m to 0.5 $\mu$m. The thickness of the carbon coating layer may be 1.4 $\mu$m, 1.3 $\mu$m, 1.2 $\mu$m, 1.1 $\mu$m, 1.0 $\mu$m, 0.9 $\mu$m, 0.8 $\mu$m, 0.7 $\mu$m, 0.6 $\mu$m, 0.5 $\mu$m, 0.4 $\mu$m, 0.3 $\mu$m, 0.2 $\mu$m, or 0.1 $\mu$m, for example. The thickness of the carbon coating layer is controlled within a suitable range, which can form a stable and complete coating film on the surface of the porous carbon base, and can help to control the specific surface area within a suitable range. Further, an SEI film (solid electrolyte interface) is not easily formed due to the fact that the coating film is too thick, which may result in loss of active lithium and affect the first efficiency of the material.

In a second aspect of the present disclosure, there is provided a preparation method of a silicon carbon negative material according to one or more of the preceding embodiments, which includes steps of:

a. depositing elemental silicon in the pores of the porous carbon base;
b. performing carbon coating treatment on a product formed in the previous step; and
c. reacting a product formed in the previous step with a lithium source.

The preparation method is performed in an order of a-b-c or a-c-b. It will be appreciated that the steps of carbon coating treatment and pre-lithiation reaction can be performed in any order, as the lithium source does not react with the carbon coating layer and may pass through the carbon coating layer to react with the elemental silicon deposited in the porous carbon base. When performing in the order of a-b-c, the "previous step" in step b refers to step a, and the "previous step" in step c refers to step b. When performing in the order a-c-b, the "previous step" in step b refers to step c, and the "previous step" in step c refers to step a.

In some embodiments, the porous carbon base satisfies at elast one of the following conditions (1) to (4).

As for condition (1), a porosity of the porous carbon base is in a range of 40% to 70% measured under nitrogen adsorption. Optionally, the porosity of the porous carbon base is in a range of 40% to 50% measured under nitrogen adsorption. For example, the porosity of the porous carbon base may be 45%, 50%, 55%, 60%, or 65% measured under nitrogen adsorption. In the raw material of the porous carbon base, the pores not only extend on the surface, but also extend to the interior of the material, such that the silicon material can deposit on the porous carbon base, which can inhibit the expansion of silicon. The porosity of the porous carbon base is controlled in a suitable range, enabling the silicon material to be uniformly deposited in the pores to form grains with a suitable particle size, and obtaining a resulting silicon carbon negative material with a suitable porosity, thereby effectively inhibiting the expansion of the silicon material and enabling the resulting product to have a sufficient mechanical strength and capacity.

As for condition (2), a pore size of the porous carbon base is in a range of 1 nm to 200 nm. Optionally, the pore size of the porous carbon base is in a range of 2 nm to 100 nm. The pore size of the porous carbon base is controlled in a suitable range, facilitating the formation of silicon grains with a suitable particle size in the pore, and inhibiting the expansion of the porous carbon base in the cycle process. It will be appreciated that the pore size of the carbon base is not absolutely constrained by the size of the nano-silicon grains, as it is not required that all pores of the porous carbon base have silicon grains deposited therein. The pores without a deposited silicon grain can reserve aperture gaps for the expansion of silicon, thereby further alleviating the material expansion.

As for condition (3), a number proportion of mesopores in the porous carbon base is in a range of 10% to 65%. Optionally, the number proportion of mesopores is in a range of 40% to 55%. For example, the number proportion of mesopores may be 15%, 20%, 25%, 30%, 35%, 40%, 45%, 50%, 55%, or 60%. The mesopore refers to a pore with a pore size in a range of 2 nm to 50 nm. The number proportion of the mesopores can be recorded as a mesoporosity. The mesoporosity of the porous carbon base is controlled to be beneficial to the uniform distribution of silicon and carbon in the material, preventing local enrichment of silicon particles in the material, and making the resulting product have a sufficient mechanical strength.

As for condition (4), a Dv50 particle size of the porous carbon base is in a range of 3 $\mu$m to 10 $\mu$m. Optionally, the Dv50 particle size of the porous carbon base is in a range fo 4 $\mu$m to 8 $\mu$m. The particle size of the porous carbon base is controlled in a suitable range to facilitate the formation of a resulting silicon carbon negative material with a suitable particle size, thereby balancing dynamic properties and the first efficiency of the material.

In some embodiments, the operation of depositing elemental silicon in step a includes steps of:

placing the porous carbon base in a vacuum chamber filled with a protective gas; and
supplying a silicon source gas into the vacuum chamber and heating the vacuum chamber so that the silicon source gas decomposes to produce elemental silicon, which is then deposited in the pores of the porous carbon base. Elemental silicon grains that are uniformly distributed and have a suirable grain size can be easily and controllably formed by filling the silicon material with a gaseous silicon source.

In some embodiments, step a satisfies one or more of the following conditions (1) to (5).

As for condition (1), the vacuum degree of the vacuum chamber is in a range of 100 Pa to 800 Pa before the protective gas is filled. The vacuum degree may be, for example, 200 Pa, 400 Pa, or 600 Pa.

As for condition (2), the protective gas includes one or more of nitrogen, argon, and hydrogen.

As for condition (3), the silicon source gas includes one or more of silane, dichlorosilane, trichlorosilane, and tetrachlorosilane.

As for condition (4), a volume ratio of the protective gas to the silicon source gas is 1:(1-10). The volume ratio may be, for example, 1:2, 1:4, 1:6, or 1:8.

As for condition (5), the heating operation includes steps of: firstly heating the temperature of the vacuum chamber to be 600°C to 1000°C, and maintaining the temperature for 1 h to 4 h; and then decreasing the temperature to be 450°C to 550°C, and maintaining the temperature for 1 h to 6 h. Optionally, the temperature may be rised to 650°C, 700°C, 750°C, 800°C, 850°C, 900°C, or 950°C and maintained for 2 h or 3 h. Thereafter the temperature may be decreased to 475°C, 500°C, or 525°C and maintain the temperature for 2 h, 3 h, 4 h, or 5 h.

Suitable deposition conditions are advantageous to allow the silicon grains to be deposited more uniformly in the pores of the porous carbon base and form particles of the proper size. For example, the volume ratio of the protective gas to the silicon source gas is configured to adjust an effective concentration of the silicon source gas. When the effective concentration of the silicon source gas is high, the reaction rate is relatively fast, which is not conducive to the deposition of silicon in the pore structure of the carbon base, resulting in uneven distribution of silicon and carbon of resulting particles. The silicon is distributed more on the surface of the resulting particles. In the cycle process, the surface expansion is too great, which may cause particle breakage and affect the cycle performance. When the effective concentration of the silicon source gas is low, the reaction is slow and the reaction time is too long, which may easily lead to the silicon grain size being larger. Accordingly, the carbon base can not effectively restrict its expansion, which may easily lead to particle breakage in the cycle process and affect the circulation. For example, at the beginning of the reaction, there are many pores in the carbon base, such that a relatively high reaction temperature can be set to enable the silicon to rapidly fill the pores. However, when the temperature exceeds 1000°C, the reaction rate is too fast, and the silicon particles directly decompose at mouths of the pores to block the pores. Accordingly, the silicon particles that are subsequently decomposed cannot continue to fill the pores. A lower reaction temperature is set in a second stage to reduce the reaction rate and allow silicon to continue to fill the remaining pores, further reducing the porosity of the material and allowing a porosity of the resulting product to be below 40%.

In some embodiments, the carbon coating treatment in step b includes steps of supplying a non-reactive gas and a carbon source gas, decomposing the carbon source gas to produce elemental carbon under heating conditions, and depositing the elemental carbon on a surface of the product formed in a preceding step to prepare the carbon coating layer. A carbon source gas is used to prepare the carbon coating layer, such that the thickness of the carbon coating layer can be conveniently controlled to achieve complete coating of the porous carbon base.

In some embodiments, step b satisfies one or more or more of the following conditions (1) to (3).

As for condition (1), the non-reactive gas includes one or more of nitrogen and argon.

As for condition (2), the carbon source gas includes one or more of methane, ethane, ethylene, and acetylene.

As for condition (3), a temperature of the heating condition is in a range of 600°C to 950°C, and a time is 0.2 h to 2 h. The heating temperature may be, for example, 650°C, 700°C, 750°C, 800°C, 850°C, or 900°C, and the time may be, for example, 0.5 h, 1 h, or 1.5 h.

Suitable carbon coating conditions are advantageous for controlling the carbon coating layer within a suitable thickness range, effectively covering voids of the surface of the porous carbon base to reduce the specific surface area of the resulting product and improve the electrical conductivity of the material.

In some embodiments, step c satisfies one or more of the following conditions (1) to (3).

As for condition (1), the lithium source includes one or more of lithium carbonate, lithium acetate, lithium oxide, lithium hydroxide, lithium chloride, butyl lithium, phenyl lithium, methyl lithium, lithium amide, and lithium hydride.

As for condition (2), a mass ratio of the product formed in a preceding step to a lithium source is 1:(0.02-0.1). The mass ratio of the product to the lithium source may be, for example, 1:0.04, 1:0.06, or 1:0.08.

As for condition (3), a reaction temperature is in a range of 400°C to 700°C. The reaction temperature may be, for example, 500°C or 600°C.

Suitable pre-lithiation conditions facilitate the formation of more desirable nano-silicon grains. For example, a $Li_xSi_y$ coating layer and an outer layer of lithium silicate salt that have proper proportions can be obtained by controlling the mass ratio of the product to the lithium source, to avoid that the outer layer of lithium silicate salt accounts for too much, and the reversible $Li_xSi_y$ coating layer accounts for too little to affect the capacity and first efficiency of the material. For another example, a suitable reaction temperature can avoid a low reaction efficiency and incomplete reaction caused by the too low temperature to form residues, and can also avoid continuous growth of the grains caused by the too high temperature. Accordingly, the size of the nano-silicon grains can be controlled within a suitable range, to further ensure the capacity and cycle performance of the material.

In some embodiments, the porous carbon base rotates and maintains a rotational speed in a range of 0.5 rpm to 3 rpm. The rotational speed may be, for example, 1 rpm, 1.5 rpm, 2 rpm, or 2.5 rpm. It is to be understood that the "preparation process" described herein may refer to the entire preparation process, or any one or more of steps a, b, and c. The raw material of the porous carbon base rotates at a speed during the preparation, to enable the silicon source gas and the carbon source gas to be more uniformly deposited on the inner voids and the surface of the porous carbon. The manner of controlling the rotation of the raw material of the porous carbon base may employ a vacuum chamber with a rotary function and set the rotational speed of the apparatus to a predetermined range.

In a third aspect of the present disclosure, there is provided use of a silicon carbon negative material according to one or more of the preceding embodiments in manufacture of a secondary battery. The silicon carbon negative material of the present disclosure is used to prepare a secondary battery, such that the capacity and first efficiency of the battery can be effectively improved, and the expansion of the silicon material can be controlled, thereby improving the cycle performance of the battery.

In a fourth aspect of the present disclosure, there is provided a secondary battery including a positive electrode plate, a negative electrode plate, and a separator disposed between the positive electrode plate and the negative electrode plate.

The negative electrode plate includes a negative electrode current collector and a negative active material layer provided on at least one surface of the negative electrode current collector, and the negative active material layer includes the silicon carbon negative material according to one or more of the preceding embodiments.

In a fifth aspect of the present disclosure, there is provided an electrical device including the preceding secondary battery.

Hereinafter, a secondary battery and an electrical device of the present disclosure will be described with reference to the accompanying drawings.

In an embodiment of the present disclosure, a secondary battery is provided.

In general, a secondary battery includes a positive electrode plate, a negative electrode plate, an electrolyte, and a separator. During charging and discharging of the battery, active ions are intercalated and deintercalated between the positive electrode plate and the negative electrode plate. The electrolyte functions to conduct ions between the positive electrode plate and the negative electrode plate. The separator is arranged between the positive electrode plate and the negative electrode plate, and mainly functions to prevent the positive and negative electrodes from being short-circuited while enabling the ions to pass therethrough.

Positive Electrode Plate

The positive electrode plate includes a positive electrode current collector and a positive electrode film layer disposed on at least one surface of the positive electrode current collector, and the positive electrode film layer includes a positive electrode active material of the first aspect of the present disclosure.

As an example, the positive electrode current collector has two surfaces opposite to each other in a thickness direction thereof, and the positive electrode film layer is disposed on any one or both of the two opposite surfaces of the positive electrode current collector.

In some embodiments, the positive electrode current collector may be a metal foil or a composite current collector. For example, the metal foil is an aluminum foil. The composite current collector may include a macromolecular material base-layer and a metal layer formed on at least one surface of the macromolecular material base-layer. The composite current collector may be formed by forming a metal material (such as, aluminum, aluminum alloy, nickel, nickel alloy, titanium, titanium alloy, silver, and silver alloy) on a macromolecular base material (such as, polypropylene (PP), polyethylene terephthalate (PET), polybutylene terephthalate (PBT), polystyrene (PS), and polyethylene (PE)).

In some embodiments, the positive electrode active material is a positive electrode active material for a battery known in the field. As an example, the positive electrode active material includes at least one of lithium-containing phosphate of an olivine structure, lithium transition metal oxide, or respective modified compounds thereof. However, the present disclosure is not limited to these materials, and other traditional materials that may be used as positive electrode active materials of the battery may be used. These positive electrode active materials may be used alone or in combinations of two or more. Examples of the lithium transition metal oxide may include, but are not limited to, at least one of lithium cobalt oxide (e.g., $LiCoO_2$), lithium nickel oxide (e.g., $LiNiO_2$), lithium manganese oxide (e.g., $LiMnO_2$, $LiMn_2O_4$), lithium nickel cobalt oxide, lithium manganese cobalt oxide, lithium nickel manganese oxide, lithium nickel cobalt manganese oxide (e.g., $LiNi_{1/3}Co_{1/3}Mn_{1/3}O_2$, which may be referred to as NCM$_{333}$), $LiNi_{0.5}Co_{0.2}Mn_{0.3}O_2$ (which may be referred to as NCM$_{523}$), $LiNi_{0.5}Co_{0.25}Mn_{0.25}O_2$ (which may be referred to as NCM$_{211}$), $LiNi_{0.6}Co_{0.2}Mn_{0.2}O_2$ (which may be referred to as NCM$_{622}$), $LiNi_{0.8}Co_{0.1}Mn_{0.1}O_2$ (which may be referred to as NCM$_{811}$), lithium nickel cobalt aluminum oxide (e.g., $LiNi_{0.85}Co_{0.15}Al_{0.05}O_2$), or modified compound thereof. Examples of the lithium-containing phosphate of olivine structure may include, but are not limited to, at least one of lithium iron phosphate (such as $LiFePO_4$, which may be referred to as LFP), a composite material of lithium iron phosphate and carbon, lithium manganese phosphate (such as $LiMnPO_4$), a composite material of lithium manganese phosphate and carbon, lithium iron manganese phosphate, or a composite material of lithium iron manganese phosphate and carbon.

In some embodiments, the positive electrode film layer further optionally includes a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, or fluorine-containing acrylate resin.

In some embodiments, the positive electrode film layer further optionally includes a conductive agent. As an example, the conductive agent may include at least one of superconducting carbon, acetylene black, carbon black, Ketjen black, carbon dots, carbon nanotubes, graphene, or carbon nanofibers.

In some embodiments, the positive electrode plate is prepared as follows. The above components for preparing the positive electrode plate, such as the positive electrode active material, the conductive agent, the binder and any other components, are dispersed in a solvent (e.g., N-methylpyrrolidone) to form positive electrode slurry. The positive electrode slurry is then coated on the positive electrode current collector, and the positive electrode plate is obtained after drying, cold pressing and other processes.

Negative Electrode Plate

The negative electrode plate includes a negative electrode current collector and a negative electrode film layer disposed on at least one surface of the negative electrode current collector, and the negative electrode film layer includes a negative electrode active material. The negative electrode active material includes the silicon carbon negative material of the first aspect of the present disclosure.

As an example, the negative electrode current collector has two surfaces opposite to each other in a thickness direction thereof, and the negative electrode film layer is disposed on any one or both of the two opposite surfaces of the negative electrode current collector.

In some embodiments, the negative electrode current collector may be a metal foil or a composite current collector. For example, the metal foil is a copper foil. The composite current collector may include a macromolecular material base-layer and a metal layer formed on at least one surface of the macromolecular material base-material. The composite current collector may be formed by forming a metal material (such as, copper, copper alloy, nickel, nickel alloy, titanium, titanium alloy, silver, and silver alloy) on a macromolecular base material (such as, polypropylene (PP), polyethylene terephthalate (PET), polybutylene terephthalate (PBT), polystyrene (PS), and polyethylene (PE)).

In some embodiments, in addition to the silicon carbon negative material described in the first aspect of the present disclosure, the negative electrode active material of the present disclosure may include negative electrode active materials known in the art for batteries, for example, artificial graphite, natural graphite, soft carbon, hard carbon, silicon-based material, tin-based material, lithium titanate, and the like. The silicon-based material may be one or more selected from a group consisting of elemental silicon, silicon-oxygen compound, silicon-carbon composite, silicon-nitrogen compound, and silicon alloy. The tin-based material may be one or more selected from a group consisting of elemental tin, tin oxide compound, and tin alloy. However, the present disclosure is not limited to these materials, and other traditional materials that may be used as the negative electrode active materials of the battery may be used. These negative electrode active materials may be used alone or in combinations of two or more.

In some embodiments, the negative electrode film layer further optionally includes a binder. The binder may be one or more selected from a group consisting of styrene butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some embodiments, the negative electrode film layer further optionally includes a conductive agent. The conductive agent may be one or more selected from a group consisting of superconducting carbon, acetylene black, carbon black, Ketjen black, carbon dots, carbon nanotubes, graphene, and carbon nanofibers.

In some embodiments, the negative electrode film layer may optionally include other additives, such as a thickening agent, e.g., sodium carboxymethyl cellulose (CMC-Na).

In some embodiments, the negative electrode plate is prepared as follows. The above components for preparing the negative electrode plate, such as the negative electrode active material, the conductive agent, the binder and any other components, are dispersed in a solvent (for example, deionized water) to form negative electrode slurry. The negative electrode slurry is then coated on the negative electrode current collector, and the negative electrode plate is obtained after drying, cold pressing and other processes.

Electrolyte

The electrolyte functions to conduct ions between the positive electrode plate and the negative electrode plate. The present disclosure has no specific limitation on the type of the electrolyte, which can be selected according to requirements. For example, the electrolyte may be in a liquid state, a gel state, or an all-solid state.

In some embodiments, the electrolyte employs an electrolytic solution. The electrolytic solution includes electrolyte salt and a solvent.

In some embodiments, the electrolyte salt may include at least one selected from a group consisting of lithium hexafluorophosphate, lithium tetrafluoroborate, lithium perchlorate, lithium hexafluoroarsenate, lithium bisfluorosulfonimide, lithium bis-trifluoromethane sulfonimide, lithium trifluoromethanesulfonate, lithium difluorophosphate, lithium difluoro(oxalato) borate, lithium bis(oxalato)borate, lithium difluoro bis(oxalato)phosphate, and lithium tetrafluorooxalato phosphate.

In some embodiments, the solvent may include at least one selected from a group consisting of ethylene carbonate, propylene carbonate, methyl ethyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, tetramethylene sulfone, dimethyl sulfone, methyl ethyl sulfone, and diethyl sulfone.

In some embodiments, the electrolytic solution further optionally includes an additive. As an example, the additive may include a negative electrode film-forming additive and a positive electrode film-forming additive, and may further include additives capable of improving performance of the battery, such as additives for improving overcharge performance of the battery and additives for improving high-temperature or low-temperature performance of the battery.

Separator

In some embodiments, the secondary battery further includes an isolation film. The type of the isolation film is not particularly limited in the present disclosure, and may be any well-known isolation film with a porous structure that has good chemical stability and mechanical stability.

In some embodiments, a material of the isolation film may be selected from at least one of glass fiber, non-woven fabric, polyethylene, polypropylene, and polyvinylidene fluoride. The isolation film may be a single-layer film or may be a multilayer composite film, which is not particularly limited. When the isolation film is a multilayer composite film, materials of the layers may be the same or different, which is not particularly limited.

In some embodiments, the positive electrode plate, the negative electrode plate and the isolation film are assembled into an electrode assembly by means of a winding process or a lamination process.

In some embodiments, the secondary battery may include an outer package. The outer package is configured to package the above electrode assembly and the electrolyte.

In some embodiments, the outer package of the secondary battery may be a hard housing, such as a hard plastic housing, an aluminum housing, and a steel housing. The outer package of the secondary battery may be a soft package, such as a bag-type soft package. A material of the soft package may be plastic, such as polypropylene, polybutylene terephthalate, and polybutylene succinate.

The shape of the secondary battery is not particularly limited in the present disclosure, and may be cylindrical, square, or any other shape. For example, FIG. illustrates a secondary battery 1 having a square structure as an example.

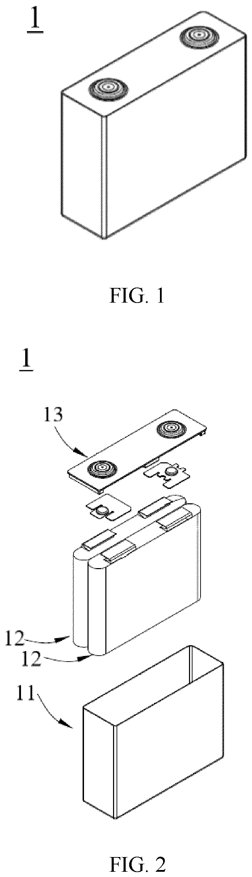

In some embodiments, referring to FIG. 2, the outer package includes a casing 11 and a cover plate 13. The casing 11 includes a bottom plate and a side plate connected to the bottom plate, and the bottom plate and the side plate enclose an accommodating cavity. The casing 11 has an opening in communication with the accommodating cavity, and the cover plate 13 can cover the opening to enclose the accommodating cavity. The positive electrode plate, the negative electrode plate and the isolation film forms an electrode assembly 12 through a winding process or a lamination process. The electrode assembly 12 is enclosed in the accommodating cavity. The electrolyte is immersed in the electrode assembly 12. The secondary battery 1 may include one or more electrode assemblies 12, and those skilled in the art can select according to specific actual requirements.

In addition, the present disclosure further provides an electrical device, and the electrical device includes at least one of the secondary battery, the battery module, or the battery pack according to the present disclosure. The secondary battery, the battery module or the battery pack may be used as a power supply for the electrical device, or may be used as an energy storage unit of the electrical device. The electrical device may include a mobile device, an electric vehicle, an electrical train, a ship, a satellite, an energy storage system, and the like, but it is not limited thereto. The mobile device may be, for example, a mobile phone, a notebook computer, and the like. The electric vehicle may be, for example, a pure electric vehicle, a hybrid electric vehicle, a plug-in hybrid electric vehicle, an electric bicycle, an electric scooter, an electric golf cart, an electric truck and the like, but is not limited thereto.

The electrical device may select the secondary battery, the battery module, or the battery pack according to use requirements thereof.

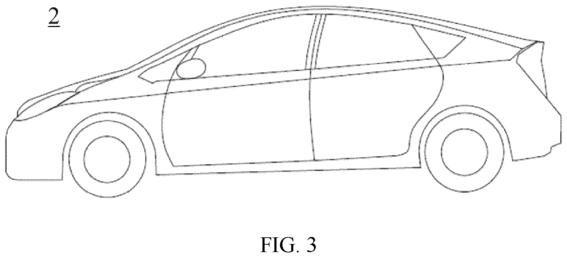

FIG. 3 illustrates an electrical device 2 as an example. The electrical device is a pure electric vehicle, a hybrid electric vehicle, a plug-in hybrid electric vehicle and the like.

In another example, the device may be a mobile phone, a tablet computer, a notebook computer and the like.

Example 1

(1) Preparation of Positive Electrode Plate

$0.4Li_2MnO_3 \cdot 0.6LiNi_{0.5}Mn_{0.5}O_2$, a conductive agent of acetylene black and a binder of polyvinylidene fluoride (PVDF) are mixed at a weight ratio of 94:4:2 and a solvent of N-methylpyrrolidone is added. They are stirred sufficiently and mixed uniformly to obtain positive electrode slurry. The positive electrode slurry is then uniformly coated on two surfaces of the positive electrode current collector of aluminium foil, which are then dried and cold-pressed to obtain a positive electrode plate.

(2) Preparation of Negative Electrode Plate

① Preparation of Porous Silicon Carbon Negative Material

a. A porous carbon base with a porosity of 48%, a pore size in a range of 2 nm to 100 nm, a mesoporosity of 45%, and a Dv50 particle size of 7.2 $\mu$m is placed in a heating chamber of a vapour deposition furnace. Thereafter the heating chamber is evacuated to 500 Pa, and is then supplied with an argon protective gas. After filling the heating chamber with the argon protective gas, silane with a volume of 5 times the volume of the protective gas is supplied, is heated to 800°C and maintains the temperature for 2 h, and is then cooled to 500°C and maintains the temperature for 3 h. In this way, the silane is decomposed to obtain elemental silicon, which is deposited in the pores of the porous carbon base.

b. Methane gas is supplied into the heating chamber and heated at 800°C for 1 h, to form a carbon coating layer with a thickness of 0.3 $\mu$m on the surface of the porous carbon base.

c. The product obtained in step b and lithium carbonate are placed in a rotary furnace filled with the argon protective gas at a mass ratio of 1:0.05. A rotational speed of the rotary furnace is predetermined to 2 rpm, and the temperature of of the rotary furnace is 600°C. The resulting product reacts with lithium carbonate to obtain a reacted product, on which particle size classification is performed to obtain a silicon carbon negative material. Relevant parameters of the silicon carbon negative material are a Dv50 particle size of 7.9 $\mu$m, a specific surface area of 2.7 $m^2$/g, and a porosity of 31.8%, wherein the mass percentage contents of elements are 48.6% for carbon element, 41.4% for silicon element, 1.2% for lithium element, and 7.8% for oxygen element. In the X-ray diffraction pattern, there is a diffraction peak between 22° and 24°, which is a characteristic peak of an $Li_{12}Si_7(221)$ crystal plane, and there is a diffraction peak between 26° and 27°, which is a characteristic peak of an $Li_2SiO_3(111)$ crystal plane.

② The porous silicon carbon negative material prepared in step ①, the conductive agent of acetylene black, the binder of SBR (styrene-butadiene rubber) and the binder of CMC (sodium carboxymethyl cellulose) are mixed at a weight ratio of 95:1.5:3.1:0.4, and a solvent of deionized water is added. They are stirred sufficiently and mixed uniformly to obtain negtive electrode slurry. The negtive electrode slurry is then uniformly coated on two surfaces of a negative electrode current collector of copper foil, which are then dried and cold-pressed to obtain a negative electrode plate.

(3) Preparation of Electrolytic Solution

In an argon atmosphere glovebox with a water content smaller than 10 ppm, EC (ethylene carbonate), PC (polycarbonate), and DMC (dimethyl carbonate) are mixed at a weight ratio of EC:PC:DMC = 3:3:3, and $LiPF_6$, VC, DTD and PS are then added. After they are stirred uniformly, an electrolytic solution is obtained, wherein an electrolytic solution concentration of the lithium ion battery of $LiPF_6$ is 1mol/L, and mass percentages of VC, DTD and PS are 3%, 1%, and 1%, respectively.

(4) Preparation of Separator

A composite film of PP, PE and PP is used as the separator.

(5) Preparation of Lithium-ion Secondary Battery

The positive electrode plate prepared in step (1), the separator in step (4) and the negative electrode plate prepared in step (2) are stacked in sequence so that the separator is located between the positive electrode plate and the negative electrode plate for isolation to obtain a bare core. The bare core is then placed in an outer package, into which the electrolytic solution prepared in step (3) is injected. Thereafter the outer package is packaged for formation to obtain a lithium-ion secondary battery.

Example 2

Example 2 is substantially the same as Example 1, except that the porosity of the porous carbon base is 75%, the pore size is in a range of 2 nm to 60 nm, the mesoporosity is 46%, and the porosity of the obtained silicon carbon negative material is 43.2%.

Example 3

Example 3 is substantially the same as Example 1, except that the Dv50 particle size of the porous carbon base is 10 μm, and the Dv50 particle size of the obtained silicon carbon negative material is 11.2 μm.

Example 4

Example 4 is substantially the same as Example 1, except that the Dv50 particle size of the porous carbon base is 3.6 μm, the thickness of the carbon coating layer is 0.5 μm, the Dv50 particle size of the obtained silicon carbon negative material is 4.7 μm, and the specific surface area is 4.2 m²/g.

Example 5

Example 5 is substantially the same as Example 1, except that the thickness of the carbon coating layer is 2.0 μm, the Dv50 particle size of the obtained silicon carbon negative material is 11.3 μm, and the mass percentage contents of elements are 48.7% for carbon element, 41.9% for silicon element, 0.4% for lithium element, and 8.8% for oxygen element.

Example 6

Example 6 is substantially the same as Example 1, except that the thickness of the carbon coating layer is 0.05 μm, the Dv50 particle diameter of the obtained silicon carbon negative material is 7.5 μm, and the specific surface area of the obtained silicon carbon negative material is 5.2 m²/g.

Example 7

Example 7 is substantially the same as Example 1. Example 7 is different from Example 1 in that in ①a of step (2), the temperature maintains at 500°C for 5 h after supplying silane, and the mass percentage contents of elements in the resulting product are 61.6% for carbon element, 28.4% for silicon element, 1.2% for lithium element, and 7.8% for oxygen element, respectively.

Example 8

Example 8 is substantially the same as Example 1. Example 8 is different from Example 1 in that in ①a of step (2), after introducing silane, the temperature was firstly increased to 1200°C and maintained for 2 h, and was then decreased to 500°C and maintained for 3 h.

Example 9

Example 9 is substantially the same as Example 1, except that in ①a of step (2), the amount of silane is 0.5 times the volume of the protective gas.

Example 10

Example 10 is substantially the same as Example 1, except that in ①a of step (2), the amount of silane is 12 times the volume of the protective gas.

Example 11

Example 11 is substantially the same as Example 1, except that the temperature in ①c of step (2) is 350°C.

Example 12

Example 12 is substantially the same as Example 1, except that the temperature in ①c of step (2) is 900°C.

Example 13

(1) Preparation of Positive Electrode Plate

$0.4Li_2MnO_3 \cdot 0.6LiNi_{0.3}Mn_{0.5}O_2$, a conductive agent of acetylene black and a binder of polyvinylidene fluoride (PVDF) are mixed at a weight ratio of 94:4:2 and a solvent of N-methylpyrrolidone is added. They are stirred sufficiently and mixed uniformly to obtain positive electrode slurry. The positive electrode slurry is then uniformly coated on two surfaces of the positive electrode current collector of aluminium foil, which are then dried and cold-pressed to obtain a positive electrode plate.

(2) Preparation of Negative Electrode Plate

① Preparation of Porous Silicon Carbon Negative Material

a. A porous carbon base with a porosity of 55%, a pore size in a range of 2 nm to 100 nm, a mesoporosity of 50%, and a Dv50 particle size of 6.4 $\mu$m is placed in a heating chamber of a vapour deposition furnace. Thereafter the heating chamber is evacuated to 500 Pa, and is then supplied with an argon protective gas. After filling the heating chamber with the argon protective gas, silane with a volume of 3 times the volume of the protective gas is supplied, is heated to 900°C and maintains the temperature for 2 h, and is then cooled to 550°C and maintains the temperature for 3 h. In this way, the silane is decomposed to obtain elemental silicon, which is deposited in the pores of the porous carbon base.
b. Methane gas is supplied into the heating chamber and heated at 700°C for 1 h, to form a carbon coating layer with a thickness of 0.4 $\mu$m on the surface of the porous carbon base.
c. The product obtained in step b and lithium hydroxide are placed in a rotary furnace filled with the argon protective gas at a mass ratio of 1:0.03. A rotational speed of the rotary furnace is predetermined to 2 rpm, and the temperature of of the rotary furnace is 600°C. The resulting product reacts with lithium hydroxide to obtain a reacted product, on which particle size classification is performed to obtain a silicon carbon negative material. Relevant parameters of the silicon carbon negative material are a Dv50 particle size of 7.4 $\mu$m, a specific surface area of 1.8 m$^2$/g, and a porosity of 32.8%, wherein the mass percentage contents of elements are 47.3% for carbon element, 40.7% for silicon element, 2.2% for lithium element, and 9.1% for oxygen element, respectively. In the X-ray diffraction pattern, there is a diffraction peak between 22° and 24°, which is a characteristic peak of an $Li_{12}Si_7(221)$ crystal plane.

② The porous silicon carbon negative material prepared in step ① , the conductive agent of acetylene black, the binder of SBR (styrene-butadiene rubber) and the binder of CMC (sodium carboxymethyl cellulose) are mixed at a weight ratio of 95:1.5:3.1:0.4, and a solvent of deionized water is added. They are stirred sufficiently and mixed uniformly to obtain negtive electrode slurry. The negtive electrode slurry is then uniformly coated on two surfaces of a negative electrode current collector of copper foil, which are then dried and cold-pressed to obtain a negative electrode plate.

(3) Preparation of Electrolytic Solution

In an argon atmosphere glovebox with a water content smaller than 10 ppm, EC (ethylene carbonate), PC (polycarbonate), and DMC (dimethyl carbonate) are mixed at a weight ratio of EC:PC:DMC = 3:3:3, and LiPF$_6$, VC, DTD and PS are then added. After they are stirred uniformly, an electrolytic solution is obtained, wherein an electrolytic solution concentration of the lithium ion battery of LiPF$_6$ is 1mol/L, and mass percentages of VC, DTD and PS are 3%, 1%, and 1%, respectively.

(4) Preparation of Separator

A composite film of PP, PE and PP is used as the separator.

(5) Preparation of Lithium-ion Secondary Battery

The positive electrode plate prepared in step (1), the separator in step (4) and the negative electrode plate prepared in step (2) are stacked in sequence so that the separator is located between the positive electrode plate and the negative electrode plate for isolation to obtain a bare core. The bare core is then placed in an outer package, into which the electrolytic solution prepared in step (3) is injected. Thereafter the outer package is packaged for formation to obtain a lithium-ion secondary battery.

Comparative Example 1

Comparative Example 1 is substantially the same as Example 1, except that in ①a of step (2), the porous carbon base and the elemental silicon are directly and physically mixed, and the mass percentages of elements in the resulting product were kept unchanged.

Comparative Example 2

Comparative Example 2 is substantially the same as Example 1, except that ①c of step (2) is removed.
The secondary batteries prepared in each of the above Examples and Comparative Examples were subjected to characterization tests, and the test results are shown in tables 1 to 4.

Table 1 Relevant characterization of resulting silicon carbon negative material

|  | Nano-silicon Grain Size/nm | $Li_xSi_y$ Coating Layer | Lithium Silicate Salt Outer Layer | Carbon Coating Layer Thickness/ $\mu m$ | Dv50 Particle Size/$\mu m$ | Porosity/ % | Specific Surface Area/ $m^2$/g |
|---|---|---|---|---|---|---|---|
| Example 1 | 4.3 | $Li_{12}Si_7$ | $Li_2SiO_3$ | 0.3 | 7.9 | 31.8 | 2.7 |
| Example 2 | 4.2 | $Li_{12}Si_7$ | $Li_2SiO_3$ | 0.3 | 7.7 | 43.2 | 2.9 |
| Example 3 | 4.1 | $Li_{12}Si_7$ | $Li_2SiO_3$ | 0.4 | 11.2 | 30.1 | 2.3 |
| Example 4 | 4.3 | $Li_{12}Si_7$ | $Li_2SiO_3$ | 0.5 | 4.7 | 28.9 | 4.2 |
| Example 5 | 4.4 | $Li_{12}Si_7$ | $Li_2SiO_3$ | 2.0 | 11.3 | 21.6 | 1.8 |
| Example 6 | 4.0 | $Li_{12}Si_7$ | $Li_2SiO_3$ | 0.05 | 7.5 | 35.4 | 5.2 |
| Example 7 | 3.2 | $Li_{12}Si_7$ | $Li_2SiO_3$ | 0.3 | 7.8 | 29.8 | 3.0 |
| Example 8 | 8.2 | $Li_{12}Si_7$ | $Li_2SiO_3$ | 0.3 | 8.0 | 33.4 | 2.8 |
| Example 9 | 9.8 | $Li_{12}Si_7$ | $Li_2SiO_3$ | 0.3 | 7.9 | 30.5 | 2.6 |
| Example 10 | 7.6 | $Li_{12}Si_7$ | $Li_2SiO_3$ | 0.3 | 8.1 | 42.8 | 2.8 |
| Example 11 | 4.6 | $Li_{12}Si_7$ | $Li_2Si_2O$ 5 | 0.3 | 7.9 | 31.8 | 2.4 |
| Example 12 | 7.8 | $Li_{12}Si_7$ | $Li_2SiO_3$ | 0.3 | 7.9 | 31.8 | 2.6 |
| Example 13 | 5.2 | $Li_{12}Si_7$ | / | 0.4 | 7.4 | 32.8 | 1.8 |
| Comparative Example 1 | 12.5 | / | / | 0.3 | 8.0 | 46.9 | 0.9 |
| Comparative Example 2 | 4.3 | / | / | 0.3 | 7.9 | 31.8 | 2.7 |

Table 2 Preparation Conditions

|  | Initial Reaction Temperature After Supplying Silane/°C | Volume Ratio of Protective Gas: Silicon Source Gas | Lithium Source Reaction Temperature/°C |
|---|---|---|---|
| Example 1 | 800 | 1:5 | 600 |
| Example 2 | 800 | 1:5 | 600 |
| Example 3 | 800 | 1:5 | 600 |
| Example 4 | 800 | 1:5 | 600 |
| Example 5 | 800 | 1:5 | 600 |
| Example 6 | 800 | 1:5 | 600 |

(continued)

|  | Initial Reaction Temperature After Supplying Silane/°C | Volume Ratio of Protective Gas: Silicon Source Gas | Lithium Source Reaction Temperature/°C |
|---|---|---|---|
| Example 7 | 500 | 1:5 | 600 |
| Example 8 | 1200 | 1:5 | 600 |
| Example 9 | 800 | 1:0.5 | 600 |
| Example 10 | 800 | 1:12 | 600 |
| Example 11 | 800 | 1:5 | 350 |
| Example 12 | 800 | 1:5 | 900 |
| Example 13 | 900 | 1:3 | 600 |
| Comparative Example 1 | / | / | 600 |
| Comparative Example 2 | 800 | 1:5 | / |

Table 3 Properties of Porous Carbon Base

|  | Porosity/% | Mesoporosity/% | Dv50 Particle Size/$\mu$m |
|---|---|---|---|
| Example 1 | 48 | 45 | 7.2 |
| Example 2 | 75 | 46 | 7.0 |
| Example 3 | 48 | 45 | 10.0 |
| Example 4 | 48 | 45 | 3.6 |
| Example 5 | 48 | 45 | 7.2 |
| Example 6 | 48 | 45 | 7.2 |
| Example 7 | 48 | 45 | 7.2 |
| Example 8 | 48 | 45 | 7.2 |
| Example 9 | 48 | 45 | 7.2 |
| Example 10 | 48 | 45 | 7.2 |
| Example 11 | 48 | 45 | 7.2 |
| Example 12 | 48 | 45 | 7.2 |
| Example 13 | 55 | 50 | 6.4 |
| Comparative Example 1 | 48 | 45 | 7.2 |
| Comparative Example 2 | 48 | 45 | 7.2 |

Table 4 Electrochemical Performance Test Results of Battery

|  | Capacity Per Gram mAh/g | First Efficiency % | Number of Cycles at 25°C | Number of Cycles at 45°C |
|---|---|---|---|---|
| Example 1 | 1610.3 | 83.5 | 1190 | 970 |
| Example 2 | 1690.3 | 76.1 | 990 | 790 |
| Example 3 | 1608.1 | 78.3 | 1050 | 830 |
| Example 4 | 1578.3 | 79.1 | 980 | 780 |
| Example 5 | 1613.2 | 80.9 | 1130 | 950 |
| Example 6 | 1568.0 | 81.2 | 1010 | 800 |
| Example 7 | 1603.2 | 78.4 | 1030 | 800 |
| Example 8 | 1553.2 | 74.5 | 980 | 770 |

(continued)

|  | Capacity Per Gram mAh/g | First Efficiency % | Number of Cycles at 25°C | Number of Cycles at 45°C |
|---|---|---|---|---|
| Example 9 | 1598.2 | 78.8 | 1050 | 880 |
| Example 10 | 1603.5 | 77.3 | 1060 | 880 |
| Example 11 | 1640.4 | 72.2 | 1180 | 900 |
| Example 12 | 1561.3 | 84.2 | 980 | 790 |
| Example 13 | 1615.3 | 83.1 | 1110 | 950 |
| Comparative Example 1 | 1548.4 | 77.5 | 870 | 720 |
| Comparative Example 2 | 1740.0 | 71.2 | 960 | 770 |

After analyzing the data in tables 1 to 4, the porosity of the porous carbon base in Example 2 is too high and the mechanical strength is insufficient, such that the effect of limiting the expansion of the silicon material is restricted, resulting in decrease in the first efficiency and cycle performance, as compared to Example 1. The particle size is larger and the uniformity of the pre-lithium is poor in Example 3, and thus the first efficiency of the material of Example 3 is lower than that of Example 1. In Example 4, the particle size is smaller and the specific surface area of the resulting product is greater, such that more electrolytic solution is consumed during circulation, and thus the performance of Example 4 is worse than that of Example 1. In Example 5, the coating layer is too thick and the pre-lithium degree is insufficient under the same pre-lithium condition, such that the pre-lithium effect is poor, and thus the first efficiency of Example 5 is lower than that of Example 1. In Example 6, the carbon coating layer is too thin, resulting in failure to form a stable and complete coating film on the surface of the material. In Example 7, after supplying the silicon source, the initial reaction temperature is lower, and silicon cannot be effectively deposited. In Example 8, after supplying the silicon source, the initial temperature is relatively high, the silicon crystal grains are larger, and silicon carbide is formed, resulting in decrease in cycle and capacity. In Example 9, the effective concentration of silane is low and the size of the formed grains is large, such that the expansion cannot be effectively inhibited. Accordingly, cracking is easily caused, and cycle is affected. In Example 10, the effective concentration of silane is high and the silicon is mainly distributed on the surface of particles, such that it tends to expand and disintegrate in the cycle process, and thus the cycle performance is deteriorated. In Example 11, when the pre-lithiation temperature is too low, the reaction efficiency is low, such that part of the lithium source may be lost, resulting in unnecessary waste. Further, the material contains more impurities after pre-lithiation, which not only fails to improve the first efficiency, but also loses more capacity. In Example 12, the pre-lithiation temperature is too high, resulting in crystal grain growth inside the particles, which is detrimental to material recycling.

In Comparative Example 1, the porous carbon base and silicon are directly and physically mixed. Since the bonding between silicon and the porous carbon base is not close enough, the resulting product has a higher porosity, and the mechanical strength of the material is not strong during the processing of the electrode plate. Accordingly, the product is easy to be fractured, and various performance of the battery may be significantly decreased. In Comparative Example 2, the pre-lithiation treatment was not carried out. Although the capacity is high, the first efficiency was very low, and thus it is difficult to satisfy practical requirements.

Characterization test methods of the present disclosure are described below.

1. XRD Test and Calculation of Crystal Grain Size

An XRD graph of samples was tested in accordance with JIS/K0131-1996 test standard. Based on the XRD graph of samples, a half-peak width $\beta$ and a diffraction angle $\theta$ of an Si(111) crystal plane were substituted into Debye-Scherrer formula to calculate the particle size of the sample.

Debye-Scherrer formula is as follows:

$$Dhkl = k\lambda/\beta\cos\theta,$$

where Dhkl denotes a particle size of a sample particle in nm, K denotes an Scherrer constant of 0.89, $\lambda$ denotes a wavelength of incident X-ray of 0.15406 nm, $\beta$ denotes a half-peak width of a diffraction peak in rad, and $\theta$ denotes a diffraction angle in degree.

2. Element Content Test

Elemental contents were determined by emission spectroscopy (Inductively coupled plasma, ICP) as follows. A silicon carbon composite material was taken as a sample, aqua regia and hydrofluoric acid (HF) were used to digest the sample, and the digested solution was taken to test the contents of elements.

3. Specific Surface Area Test

The specific surface area was tested by a gas adsorption method in accordance with GB/T19587-2017 test standard, and the details were as follows. A silicon carbon composite was taken as the sample, a sample tube was immersed in liquid nitrogen at -196°C, and adsorption amounts of nitrogen on a solid surface were measured under different pressures at a relative pressure in a range of 0.05-0.30. The specific surface area of the solid was calculated by calculating the monolayer adsorption amount of the sample based on the BET multilayer adsorption theory and its formula.
BET formula is as follows:

$$\frac{p/p_0}{n_a(1-p/p_0)} = \frac{1}{n_m C} + \frac{C-1}{n_m C}\frac{p}{p_0},$$

where $n_a$ denotes an amount of an adsorbed gas in mol/g, $p/p_0$ denotes a relative pressure, and $n_m$ denotes a monolayer adsorption capacity.

4. Test for Thickness of Carbon Coating Layer

An ion cross-section polishing profile of the sample was tested by a scanning electron microscope method in accordance with JY/T010-1996 test standard. A thickness of a conductive coating layer outside the material body was measured based on the cross-section profile.

5. Particle Size Test

The particle size distribution was measured by a laser diffraction particle diameter distribution measuring instrument (Malvern Mastersizer 3000) in accordance with the particle size distribution laser diffraction method GB/T19077-2016 to obtain a Dv50 particle size.

6. Determination of Pore Size

The pore size was tested by a gas adsorption method in accordance with GB/T19587-2017 & GB/T21650.2-2008 test standard, and the details are as follows. A sample was placed in a sample tube and immersed in liquid nitrogen at -196°C. Nitrogen was adsorbed on the material to be tested under a relative pressure of 0-1, and the pore size distribution of the porous material is characterized on the basis of a relation graph of volumes corresponding to various pore sizes versus corresponding partial pressures.

7. Determination of Porosity

The true density method was used to test the porosity, and the true density and apparent density of the sample were obtained in accordance with GB/T24586 test standard.
The porosity is caculated based on the formula $P=(V_2-V_1)/V_2 \times 100\%$, and the apparent volume is caculated based on the formula $V2=S \times H \times A$, in the formula:

S denotes area in $cm^2$;
H denotes thickness in cm;
A denotes number of samples in EA;
$V_1$ denotes true volume of a sample in $cm^3$, and is tested to be determined; and
$V_2$ denotes sample apparent volume in $cm^3$.

8. First Efficiency Test of Material

At ambient temperature condition, the battery was allowed to stand for 3 h, was then discharged to a voltage of 0.005 V at a constant current of 0.05 C, and was further discharged to a voltage of 0.005 V at a constant current of 50 μA. In this case, the capacity was recorded as a lithium intercalation capacity. After standing for 5 minutes, the battery was charged to a voltage of 0.8 V at rate of 0.1 C, and the capacity at this moment was recorded as a delithiation capacity.

Material First Efficiency (%) = (Delithiation Capacity/Lithium Intercalation Capacity) × 100%.

9. Material Cycle Test

(1) Cycle Performance Test at Ambient Temperature

The test was performed at the ambient temperature condition. The battery was charged at a rate of 0.5 C, was discharged at a rate of 0.5 C, and was subjected to full charge and discharge cycle test until the capacity was attenuated to 80% of the initial capacity.
The test process is described as follows. The battery was allowed to stand for 30 minutes, was then charged to a voltage of 4.2 V at a rate of 0.5 C, and was further charged to a current of 0.05 C at a constant voltage of 4.2 V and stood for 5 minutes. After that, the battery was discharged to a voltage of 2.8 V at a rate of 0.5 C. This process is a charge-discharge cycle process. The discharge capacity was recorded during each cycle.

Capacity retention rate after n cycles (%) = (discharge capacity of the nth cycle / discharge capacity of the first cycle) × 100%.

(2) Cycle Performance Test at 45°C

The test was performed at 45°C. The battery was charged at a rate of 1 C, was discharged at a rate of 1 C, and was subjected to a full charge and discharge cycle test until the capacity of the secondary battery was attenuated to 80% of the initial capacity.
The test process is described as follows. The battery was allowed to stand for 30 minutes, was then charged to a voltage of 4.2 V at a rate of 1 C, and was further charged to a current of 0.05 C at a constant voltage of 4.2 V and stood for 5 minutes. After that, the battery was discharged to a voltage of 2.8 V at a rate of 1 C. This process is a charge-discharge cycle process, and the discharge capacity was recorded during each cycle.

Capacity retention rate after n cycles of the secondary battery (%) = (discharge capacity of the nth cycle / discharge capacity of the first cycle) × 100%.

Various technical features of the above examples can be combined in any combination. In order to make the description concise, not all the possible combinations of various technical features in the above examples are described. However, as long as there is no contradiction between the combinations of these technical features, they should be considered as the scope of the description.
The examples set forth above represent only a few of embodiments of the present disclosure, and are described in more detail, but are not to be construed as limition on the scope of the present disclosure. It should be noted that those skilled in the art could make several changes and modifications without departing from the concept of the present disclosure, which falls within the scope of the present disclosure. Accordingly, the scope of the present disclosure should refer to claims below.

**Claims**

1. A silicon carbon negative material, comprising:

    a porous carbon base;
    nano-silicon crystal grains located at least partially in pores of the porous carbon base; and
    a carbon coating layer located on at least part of a surface of the porous carbon base or the nano-silicon crystal grains,
    wherein the nano-silicon crystal grains comprise an elemental silicon core and a $Li_xSi_y$ coating layer, x is an integer selected from 7 to 22, and y is an integer selected from 3 to 7.

2. The silicon carbon negative material according to claim 1, wherein the nano-silicon crystal grains satisfy one or more of the following conditions (1) to (3):

(1) a size of each of the nano-silicon grains is smaller than 10 nm; optionally, the size of the nano-silicon grain is in a range of 1 nm to 6 nm;

(2) a material of the $Li_xSi_y$ coating layer comprises one or more of $Li_7Si_3$, $Li_{12}Si_7$, $Li_{13}Si_4$, $Li_{15}Si_4$, and $Li_{22}Si_5$; or

(3) an outer layer of lithium silicate salt is provided on at least part of a surface of the $Li_xSi_y$ coating layer; optionally, a material of the outer layer of lithium silicate salt comprises one or more of $Li_2SiO_3$, $Li_4SiO_4$, and $Li_2Si_2O_5$.

3. The silicon carbon negative material according to claim 1 or 2, wherein the silicon carbon negative material satisfies one or more of the following conditions (1) to (6):

(1) a porosity of the silicon carbon negative material is smaller than 40% as measured under nitrogen adsorption; optionally, the porosity of the silicon carbon negative material is in a range of 20% to 35% as measured under nitrogen adsorption;

(2) a specific surface area of the silicon carbon negative material is smaller than 6 $m^2/g$; optionally, the specific surface area of the silicon carbon negative material is in a range of 1 $m^2/g$ to 4 $m^2/g$;

(3) a Dv50 particle size of the silicon carbon negative material is in a range of 5 $\mu m$ to 11 $\mu m$; optionally, the Dv50 particle size of the silicon carbon negative material is in a range of 7 $\mu m$ to 9 $\mu m$;

(4) in the silicon carbon negative material, a mass percentage content of a carbon element is in a range of 35% to 60%, a mass percentage content of a silicon element is in a range of 30% to 60%, a mass percentage content of a lithium element is in a range of 0.5% to 5%, and a mass percentage content of an oxygen element is in a range of 2% to 10%;

(5) an X-ray diffraction pattern of the silicon carbon negative material has a diffraction peak in a range of 22° to 24°; or

(6) the X-ray diffraction pattern of the silicon carbon negative material has a diffraction peak in a range of 26° to 27°.

4. The silicon carbon negative material according to any one of claims 1 to 3, wherein a thickness of the carbon coating layer is equal to or smaller than 1.5 $\mu m$; optionally, the thickness of the carbon coating layer is in a range of 0.1 $\mu m$ to 0.5 $\mu m$.

5. A preparation method of the silicon carbon negative material according to any one of claims 1 to 4, comprising steps of:

a. depositing elemental silicon in the pores of the porous carbon base;

b. performing carbon coating treatment on a product formed in the previous step; and

c. reacting a product of the previous step with a lithium source,

wherein the preparation method is performed in an order of a-b-c or a-c-b.

6. The preparation method according to claim 5, wherein the porous carbon base satisfies one or more of the following conditions (1) to (4):

(1) a porosity of the porous carbon base is in a range of 40% to 70% as measured under nitrogen adsorption; optionally, the porosity of the porous carbon base is in a range of 40% to 50% as measured under nitrogen adsorption;

(2) a pore size of the porous carbon base is in a range of 1 nm to 200 nm; optionally, the pore size of the porous carbon base is in a range of 2 nm to 100 nm;

(3) a number proportion of mesopores in the porous carbon base is in a range of 10% to 65%; optionally, the number proportion of mesopores is in a range of 40% to 55%; wherein the mesopores are pores having a pore size in a range of 2 nm to 50 nm; or

(4) a Dv50 particle size of the porous carbon base is in a range of 3 $\mu m$ to 10 $\mu m$; optionally, the Dv50 particle size of the porous carbon base is in a range of 4 $\mu m$ to 8 $\mu m$.

7. The preparation method according to claim 5 or 6, wherein the depositing elemental silicon in step a comprises:

placing the porous carbon base in a vacuum chamber filled with a protective gas; and

supplying a silicon source gas into the vacuum chamber and heating the vacuum chamber, decomposing the silicon source gas to form elemental silicon, and depositing the elemental silicon in the pores of the porous carbon base.

8. The preparation method according to claim 7, wherein step a satisfies one or more of the following conditions (1) to (5):

(1) a vacuum degree of the vacuum chamber is in a range of 100 Pa to 800 Pa before the protective gas is filled;
(2) the protective gas comprises one or more of nitrogen, argon, and hydrogen;
(3) the silicon source gas comprises one or more of silane, dichlorosilane, trichlorosilane, and tetrachlorosilane;
(4) a volume ratio of the protective gas and the silicon source gas is 1:(1-10); or
(5) the heating the vacuum chamber comprises:

increasing a temperature of the vacuum chamber to be in a range of 600°C to 1000°C, and maintaining the temperature for 1 h to 4 h; and
decreasing the temperature to be in a range of 450°C to 550°C, and maintaining the temperature for 1 h to 6 h.

9. The preparation method according to any one of claims 5 to 8, wherein the carbon coating treatment in step b comprises:
supplying a non-reactive gas and a carbon source gas, decomposing the carbon source gas to form elemental carbon under heating conditions, and depositing the elemental carbon on a surface of a product obtained in the preceding step to prepare the carbon coating layer.

10. The preparation method according to claim 9, wherein step b satisfies one or more of the following conditions (1) to (3):

(1) the non-reactive gas comprises one or more of nitrogen and argon;
(2) the carbon source gas comprises one or more of methane, ethane, ethylene, and acetylene; or
(3) the heating conditions comprise a temperature in a range of 600°C to 950°C and a duration in a range of 0.2 h to 2 h.

11. The preparation method according to any one of claims 5 to 10, wherein step c satisfies one or more of the following conditions (1) to (3):

(1) the lithium source comprises one or more of lithium carbonate, lithium acetate, lithium oxide, lithium hydroxide, lithium chloride, butyl lithium, phenyl lithium, methyl lithium, lithium amide, and lithium hydride;
(2) a mass ratio of the product obtained in the preceding step to the lithium source is 1:(0.02-0.1); or
(3) a reaction temperature is in a range of 400°C to 700°C.

12. The preparation method according to any one of claims 5 to 11, wherein the porous carbon base rotates and maintains a rotational speed in a range of 0.5 rpm to 3 rpm during the preparation.

13. Use of the silicon carbon negative material according to any one of claims 1 to 4 in preparation of a secondary battery.

14. A secondary battery, comprising:

a positive electrode plate;
a negative electrode plate; and
a separator provided between the positive electrode plate and the negative electrode plate,
wherein the negative electrode plate comprises a negative electrode current collector and a negative active material layer provided on at least one surface of the negative electrode current collector, the negative active material layer comprises the silicon carbon negative material according to any one of claims 1 to 4.

15. An electrical device, comprising the secondary battery according to claim 14.

FIG. 1

FIG. 2

2

FIG. 3

# EP 4 510 220 A1

## INTERNATIONAL SEARCH REPORT

| International application No. |
|---|
| **PCT/CN2022/117824** |

### A. CLASSIFICATION OF SUBJECT MATTER

H01M 4/134(2010.01)i;H01M 4/1395(2010.01)i

According to International Patent Classification (IPC) or to both national classification and IPC

### B. FIELDS SEARCHED

Minimum documentation searched (classification system followed by classification symbols)

IPC: H01M

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT; ISI: 宁德时代新能源, 硅碳, 负极, 多孔碳, 纳米硅, 锂硅合金, 硅锂合金, 包覆, 锂化, 核, 壳, 芯, 鞘, 硅化锂, 硅酸锂, 亚硅酸锂, Li??Si?, Li2SiO3, Li4siO4, Li2Si2O5, anode, carbon, silicon, porous, nano+, alloy, coat???, cover???, lithiation

### C. DOCUMENTS CONSIDERED TO BE RELEVANT

| Category* | Citation of document, with indication, where appropriate, of the relevant passages | Relevant to claim No. |
|---|---|---|
| X | CN 114944470 A (ZHEJIANG C-ONE NEW ENERGY CO., LTD.) 26 August 2022 (2022-08-26) <br> description, paragraphs [0004]-[0240] | 1-15 |
| A | CN 113380998 A (XIA XIUMING) 10 September 2021 (2021-09-10) <br> description, paragraphs [0008]-[0156] | 1-15 |
| A | CN 110729460 A (SHANDONG YUHUANG NEW ENERGY TECHNOLOGY CO., LTD.) 24 January 2020 (2020-01-24) <br> description, paragraphs [0008]-[0071] | 1-15 |
| A | CN 102214817 A (TSINGHUA UNIVERSITY) 12 October 2011 (2011-10-12) <br> description, paragraphs [0005]-[0037] | 1-15 |
| A | CN 112382742 A (YINLONG ENERGY CO., LTD.) 19 February 2021 (2021-02-19) <br> description, paragraphs [0003]-[0128] | 1-15 |
| A | CN 111916704 A (ZHUHAI COSMX BATTERY CO., LTD.) 10 November 2020 (2020-11-10) <br> description, paragraphs [0003]-[0145] | 1-15 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 March 2023** | **30 March 2023** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
**Information on patent family members**

International application No.

**PCT/CN2022/117824**

| Patent document cited in search report | | | Publication date (day/month/year) | Patent family member(s) | Publication date (day/month/year) |
|---|---|---|---|---|---|
| CN | 114944470 | A | 26 August 2022 | None | |
| CN | 113380998 | A | 10 September 2021 | None | |
| CN | 110729460 | A | 24 January 2020 | None | |
| CN | 102214817 | A | 12 October 2011 | None | |
| CN | 112382742 | A | 19 February 2021 | None | |
| CN | 111916704 | A | 10 November 2020 | None | |

Form PCT/ISA/210 (patent family annex) (July 2022)